# EUROPEAN PATENT APPLICATION

(11) **EP 2 508 789 A1**
(43) Date of publication of application: **10.10.2012**
(21) Application number: 10834442.5
(22) Date of filing: 18.10.2010
(51) Int. Cl.: F21S 2/00, F21V 23/06, G02F 1/13357, H01L 33/00, H01L 33/52, F21Y 101/02

(54) **ILLUMINATION DEVICE, AND DISPLAY DEVICE**

(30) Priority: 02.12.2009 JP 2009274385
(71) Applicant: Sharp Kabushiki Kaisha, Osaka-shi, Osaka 545-8522 (JP)
(72) Inventor: NOZAWA, Shinnosuke, Osaka-shi, Osaka 545-8522 (JP)
(74) Representative: Müller-Boré & Partner Patentanwälte
(86) International application number: PCT/JP2010/068266
(87) International publication number: WO 2011/067989

(57) **Abstract**

Provided is an illumination device in which it is possible to suppress a member mounted with a light source such as an LED from being displaced, and to make said member and the illumination device smaller. A backlight unit (49) is provided with a plurality of mounting substrates (11) having various shapes, wherein the shapes are formed in a manner such that if at least one mounting substrate (11) were to move in either of two intersecting directions in the plane of the substrate, the two neighboring mounting substrates would be shaped so as to come into contact with and restrict one of the other neighboring mounting substrates (11).

## Description

### Technical Field

The present invention relates to an illumination device that supplies light to a display panel which is used for a television set, a digital signage or the like, and to a display device that includes the illumination device and the display panel.

### Background Art

In a liquid crystal display device (display device) that incorporates a liquid crystal display panel (display panel) of non-light emitting type, usually, a backlight unit (illumination device) for supplying light to the liquid crystal display panel also is incorporated. There are various kinds of light sources in a backlight unit. For example, in case of a backlight unit disclosed in a patent document 1, the light source is an LED (Light Emitting Diode).

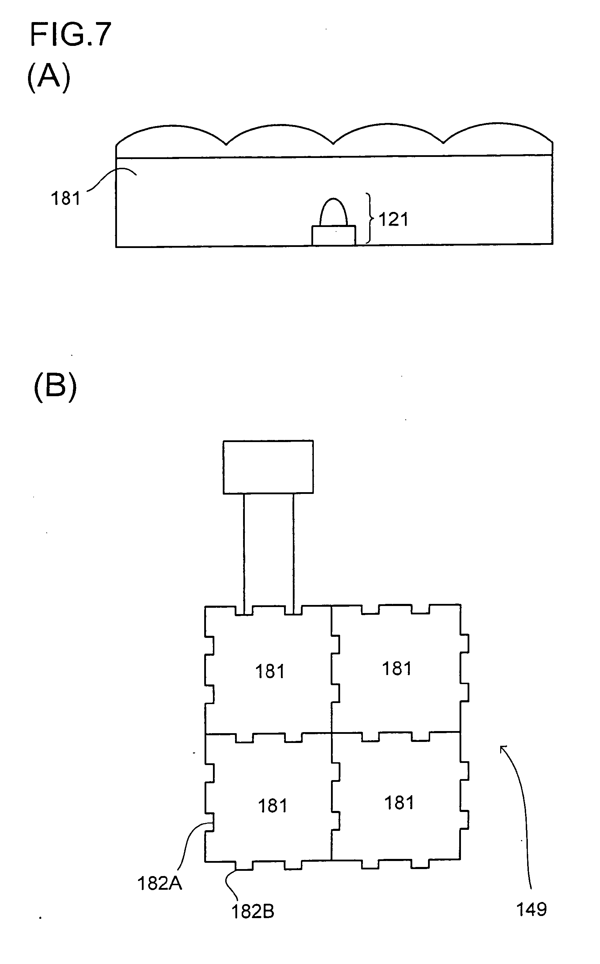

In the backlight unit described in this patent document 1, as shown in a sectional view of Fig. 7A, an area light emitting source 181 houses an LED 121. And, a circumference of this area light emitting source 181, as shown in a plane view of Fig. 7B, is provided with a concave portion 182A and a convex portion 182B. Because of this, in case where the area light emitting sources 181 neighbor each other, the concave portion 182A and the convex portion 182B fit in each other, whereby each area light emitting source 181 is unlikely to deviate.

### Citation List

### Patent Literature

PLT1: JP-A-2009-176899

### Summary of Invention

### Technical Problem

However, in the backlight unit 149 described in the patent document 1, thanks to the concave portion 182A and the convex portion 182B formed on the circumference of the area light emitting source 181, the area light emitting source 181 becomes large. As a result of this, also the backlight unit 149 incorporating a plurality of the area light emitting sources 181 becomes large.

The present invention has been made to solve the above problems. And, it is an object of the present invention to provide an illumination device that alleviates deviation of a member (e.g., a mount board for mounting an LED) on which a light source such as an LED or the like is mounted, makes the member small to achieve size reduction.

### Solution to Problem

The illumination device includes a light source and a plurality of mount boards on which the light source is mounted. And, in this illumination device, the plurality of mount boards are disposed so as to be in tight contact with one another; a shape of the mount board is a polyomino; at least one kind of the shape includes a portion of a circumference of the mount board that defines an L-shaped portion which encloses a neighboring mount board.

The polyomino is a polygon formed by connecting edges of a plurality of squares to one another. And, there are a plurality of kinds of polygons; when at least one kind of polygon includes a circumference of the mount board that defines an L-shaped portion which encloses a neighboring mount board, the mount board including the L-shaped portion is situated so as to fit another mount board in the L-shaped portion. Accordingly, of the neighboring mount boards, even if a try is performed to move one mount board to the L-shaped portion, the one mount board comes into contact with the other mount board that includes the L-shaped portion and does not move. As a result of this, in this illumination device, although a plurality of the mount boards are incorporated, each mount board is unlikely to deviate.

In addition, a shape is formed, with which neighboring mount boards restrict each other as a whole; accordingly, the circumference of the mount board does not need a dedicated engagement portion (e.g., a concave portion and a convex portion that mesh with each other). Because of this, the mount board becomes the smaller because the mount board does not have the dedicated engagement portion.

Here, it is desirable that the plurality of mount boards disposed so as to be in tight contact with each other include: mount boards having an identical kind of shape and mount boards having different kinds of shapes mingled with each other; only mount boards having the different kinds of shapes; or mount boards having the identical kind of shape. In short, if the neighboring mount boards are in tight contact with each other as if they grip each other, the kind of shape of the mount board is not especially limited.

For example, as the kind of shape of the mount board, there may be seven kinds of shapes that include: an I shape; a first L shape that is an L shape; a second L shape obtained by turning over the first L shape; a first step shape that is a step shape; a second step shape obtained by turning over the first step shape; a T shape; and a quadrangular shape.

Here, the mount boards having various shapes are each an aggregate of a plurality of mount board pieces; and as a kind of shape of the mount board piece, there may be a single kind of shape or a plurality of kinds of shapes. In short, if the mount board has a predetermined shape, the kind of shape of the mount board piece included is not especially limited.

Besides, it is desirable that every one of the mount boards includes the mount board pieces to the number of four as a whole; and at least one light source is disposed on every one of the mount board pieces. A reason is that according to this, many kinds of light sources are included in the mount board and it becomes possible to suitably change a distribution density of the light sources.

Here, it is desirable that a connector, which includes a positive terminal electrically connected to a positive electrode of the light source and a negative terminal electrically connected to a negative electrode of the light source, is mounted on a circumference of the mount boards having the various shapes; and the terminals having identical electrodes of the connectors of neighboring mount boards are electrically connected to each other. Especially, in case where every one of the mount boards is an aggregate of four mount board pieces having shapes identical to one another; and on every one of the mount board pieces, the light source is mounted, it is desirable that the connector is mounted on every circumference of the mount board pieces corresponding to the circumference of the mount board. A reason is that according to this, no matter how the mount boards neighbor one another so as to be in tight contact with one another, the connectors of the mount boards are electrically connected to one another.

Besides, as an example of the light source, there is a light emitting element. Here, a plurality of the light emitting elements may include a red light emitting element, a green light emitting element, and a blue light emitting element mingled with one another, or may be white light emitting elements.

Here, it is desirable that the illumination device includes a power adjustment portion that adjusts an amount of power supplied to the light source.

Besides, it is desirable that the illumination device includes a diffusion member that diffuses light from the light source, and it is desirable that the illumination device includes a brightness improvement member that transmits the light from the light source to improve brightness.

Besides, it is sayable that a display device, which includes the illumination device and a display panel (e.g., a liquid crystal display panel) that receives the light from the illumination device, is also the present invention.

### Advantageous Effects of Invention

According to the present invention, in an illumination device, even if a plurality of mount boards are disposed, these mount boards are unlikely to deviate and the plurality of mount boards become small as a whole.

### Brief Description of Drawings

[Fig. 1] is a plan view showing a mount board of a backlight unit.
[Fig. 2](A) to (G) are each a plan view showing a shape of a mount board.
[Fig. 3] is an enlarged plan view of a mount board piece.
[Fig. 4] (A) and (B) are each a plan view showing a disposition example of a mount board.
[Fig. 5] is a perspective view showing a display device that is used for a digital signage.
[Fig. 6] is an exploded perspective view (schematic view) in case where a display device is a liquid crystal display device.
[Fig. 7](A) is a sectional view of an area light emitting source that includes an LED contained in a conventional backlight unit; (B) is a plan view showing a plurality of area light emitting sources that are arranged in parallel with one another.

### Description of Embodiments

An embodiment is described based on drawings as follows. Here, for the sake of convenience, there is case where member numbers and the like are omitted; in such a case, other drawings are referred to.

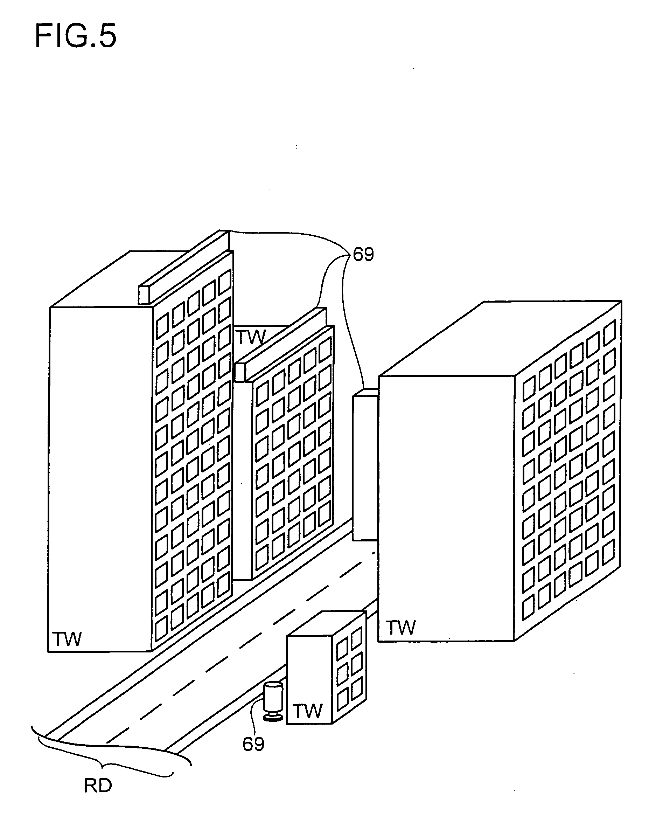

Fig. 5 is a perspective view showing an example of a digital signage. In detail, as shown in Fig. 5, a display device 69 mounted on a building BG that faces a road RD or the display device 69 disposed in front of the building BG plays a role of a digital signage.

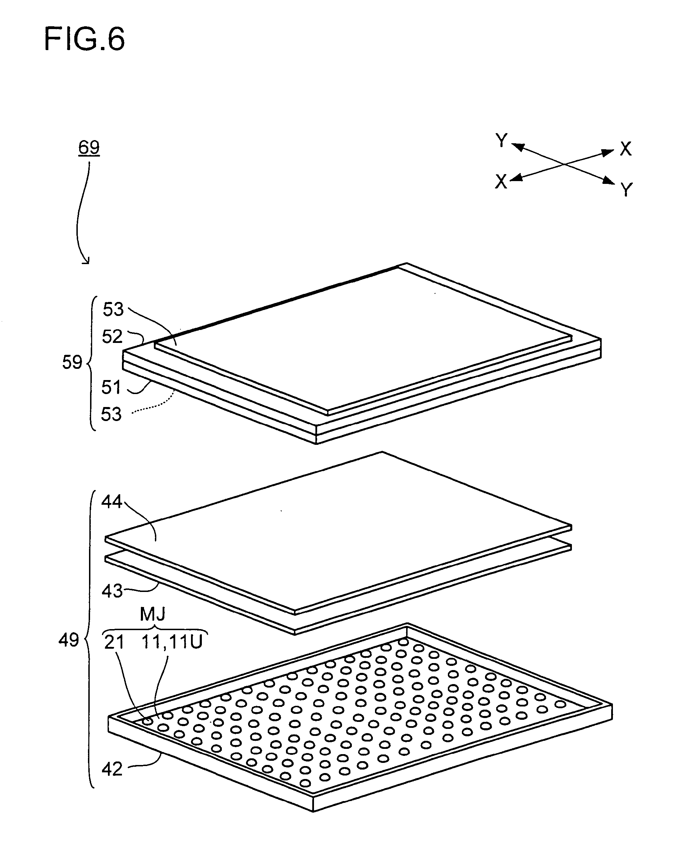

In case where the display device 69 is, for example, a liquid crystal display device, as shown in a schematic view of Fig. 6, the display device 69 includes a liquid crystal display panel (display panel) 59 and a backlight unit (illumination device) 49 that supplies light to the liquid crystal display panel 59.

The liquid crystal display panel 59 attaches an active matrix board 51 that includes switching elements such as a TFT (Thin Film Transistor) and the like to an opposite board 52 opposing the active matrix board 51 by means of a seal material (not shown). And, liquid crystal (not shown) is injected into a gap between both boards 51 and 52.

Here, a light polarization film 53 is disposed on a light receiving side of the active matrix board 51 and an output side of the opposite board 52. And, the above liquid crystal display panel 59 makes use of a change in light transmittance due to an inclination of liquid crystal molecules, thereby displaying an image.

Next, the backlight unit 49, which is situated right under the liquid crystal display panel 59, is described. The backlight unit 49 includes: an LED module (light emitting module) MJ; a diffusion plate 43; and a brightness improvement film 44 (here, a housing that houses these members is called a backlight chassis 42).

The LED module MJ includes: LEDs (Light Emitting Diode) 21 that are each a light emitting element which defines a point light source; and a mount board 11 on which the LEDs are mounted. Details of these are described later.

The diffusion plate (diffusion member) 43 is a plate-shaped optical member that overlies a mount board surface 11 U (mount surface 11U of the mount board 11) crammed with the LEDs 21, receives the light emitted from the LED module MJ, and diffuses the light. In other words, the diffusion plate 43 diffuses area light formed by the plurality of the LED modules MJ and spreads the light throughout the entire region of the liquid crystal display panel 59.

The brightness improvement film (brightness improvement member) 44 is, for example, an optical member that has a prism shape on a sheet surface, deflects a light radiation characteristic, and is situated to cover the diffusion plate 43. Because of this, this brightness improvement film 44 collects the light traveling from the diffusion plate 43 to improve brightness.

And, the above backlight unit 49 transmits the area light (backlight) formed by the LED module MJ through the plurality of the optical members 43 and 44, and supplies the light to the liquid crystal display panel 59. In this way, the liquid crystal display panel 59 of non-light emitting type receives the backlight from the backlight unit 49 and improves a display function.

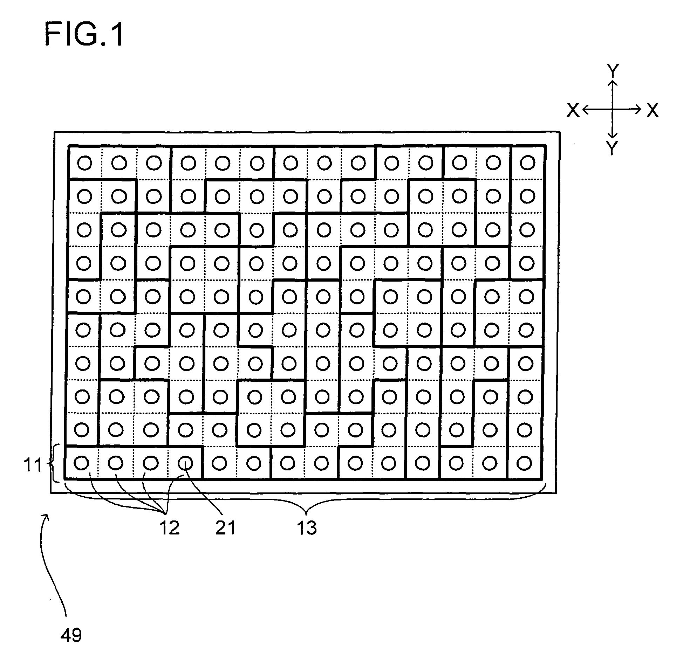

Here, the LED module MJ is described in detail by means of Fig. 1. Fig. 1 is a plan view that shows chiefly the LED module MJ of the backlight unit 49. As shown in this figure, the backlight unit 49 is crammed with the LEDs 21(here, in Fig. 1, a connector 35 and the like described later are skipped for the sake of convenience).

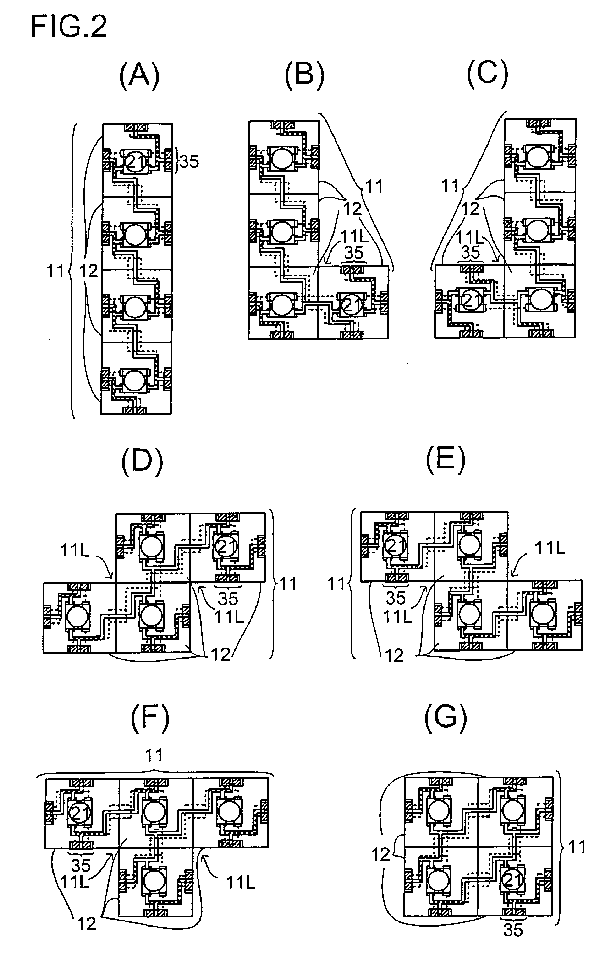

In detail, the LED 21 is mounted on the mount board piece 12. Here, an aggregate composed of four mount board pieces 12 is defined as the mount board 11. And, as the shape of the mount board 11, as shown in Fig. 2A to Fig. 2G, there are a plurality of kinds of shapes (here, the shape is a shape of the entire mount board 11 that changes in accordance with a way of arrangement of the mount board piece 12).

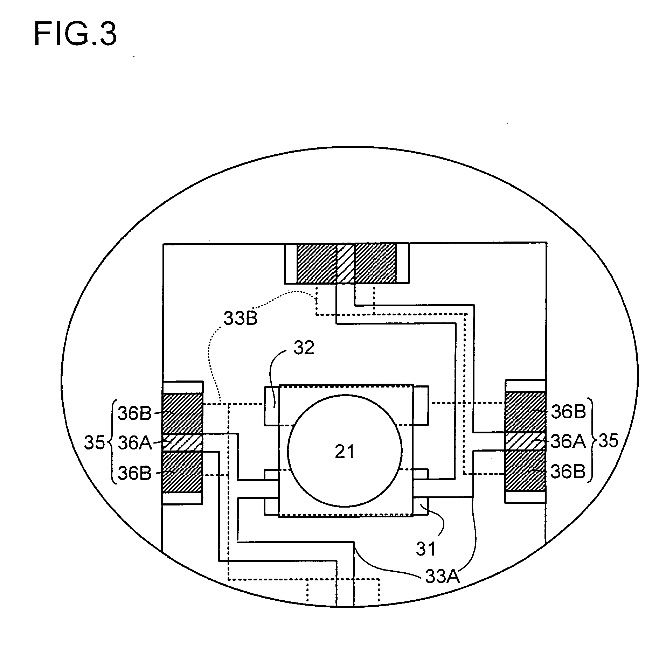

Fig. 2A shows the mount board 11 in which the four mount pieces 12, on each of which the LED 21 is mounted, are arranged in a line like a Roman letter I (here, Fig. 3 is an enlarged plan view of the mount board piece 12). Here, a way of connecting the mount board pieces 12 to one another is not especially limited; for example, they may be bonded by means of an adhesive or fixed by means of a fixing tool.

Fig. 2B shows the mount board 11 in which the four mount board pieces 12, on which the LED 21 is mounted, are arranged like a Roman letter L. Fig. 2C shows the mount board 11 that has a shape obtained by turning over the L-shaped (first L shape) mount board 11 shown in Fig. 2B. Here, the turned-over L shape shown in Fig. 2C is called a second L shape. Here, as shown in Fig. 2B and Fig. 2C, a portion of a circumference of the mount board 11 defines an L-shaped portion (L-shaped portion 11L) that encloses a neighboring mount board 11.

Fig. 2D shows the mount board 11 having a step shape in which the four mount board pieces 12 are arranged so as to form an upward step from a left side to a right side of the figure. Fig. 2E shows the mount board 11 that has a shape obtained by turning over the step-shaped (first step shape) mount board 11 shown in Fig. 2D. Here, the turned-over step shape, that is, the step shape, which forms an upward step from the right side to the left side of the figure, is called a second step shape. Here, as shown in Fig. 2D and Fig. 2E, a portion of a circumference of the mount boards 11 defines the L-shaped portion 11 L that encloses a neighboring mount board 11.

Fig. 2F shows the mount board 11 in which the four mount pieces 12, on each of which the LED 21 is mounted, are arranged like a Roman letter T. Fig. 2G shows the mount board 11 in which the four mount board pieces 12 are arranged in a quadrangular shape. Here, as shown in Fig. 2F, a portion of a circumference of the mount board 11 defines the L-shaped portion 11 L that encloses a neighboring mount board 11.

The shape of each of the mount boards 11 shown in Fig. 2A to Fig. 2G is formed by the aggregate of the four mount board pieces 12 that have shapes (square) identical to one another. These shapes are called a polyomino (a polygon formed by connecting edges of a plurality of squares to one another). Especially, the shapes of the mount boards 11 shown in Fig. 2A to Fig. 2G are each one of seven kinds of one-side tetrominos (a way of expressing a one-side tetromino is described later).

Accordingly, as shown in Fig. 1, in case where a plurality of the mount boards 11 are disposed with no gap so as to be in tight contact with one another (laid with no gap), a large mount board 11 is formed (here, the aggregate of the mount boards 11 gathered so as to be in tight contact with one another is called a mount board unit 13). And, the shape of the mount board 11 is a polyomino, and it is sayable that at least one kind of shape includes the portion 11 L having the L shape defined by a portion of the circumference of the mount board 11 (here, the L-shaped portion 11L is formed by edges of a plurality of the mount board pieces 12 intersecting each other).

As described above, when the L-shaped portion 11L defined by the circumference of the mount board 11 is formed, the mount board 11 including the portion 11 L is situated so as to fit another mount board 11 in the L-shaped portion 11 L. Accordingly, of the neighboring mount boards 11, even if a try is performed to move one mount board 11 to the L-shaped portion 11L, the one mount board 11 comes into contact with the other mount board 11 that includes the L-shaped portion 11L and does not move.

As a result of this, each mount board 11 becomes unlikely to deviate in surface directions (in short, in all directions of the board surface) in the board surface of the large mount board 11. In detail, even if one mount board 11 tries to move, other mount boards 11 restrict the one mount board 11 to stop the movement. Accordingly, each mount board 11 becomes unlikely to deviate.

For example, in case where individual mount board pieces 12 are gathered to form a large mount board 11 without being in contact with one another (in short, in case where the mount board pieces 12 are disposed in a matrix shape), if one mount board piece 12 tries to move, for example, along orthogonal two directions (X direction, Y direction) of the mount board piece 12, also other mount board pieces 12 in contact with the one mount board piece move as a whole.

However, when the mount board pieces 12 having various kinds of shapes are gathered to form the large mount board 11 as shown in Fig. 1, even if one mount board 11 tries to move in the orthogonal two directions (X direction, Y direction) of the mount board piece 12, other mount boards 11 restrict the one mount board 11 to stop the movement. Because of this, the plurality of mount boards 11 do not deviate from the rest of the mount boards 11 as a whole. In other words, in this backlight unit 49, the mount boards 11 are stably disposed without deviating (in short, the strength of the mount board unit 13 increases).

Besides, it is sayable that each mount board 11 shown in Fig. 2A to Fig. 2G has a shape capable of restricting. In other words, each mount board 11 shown in Fig. 2A to Fig. 2G has no dedicated portions, for engagement between the mount boards 11, such as a concave portion and a convex portion that are formed on a dedicated engagement portion, for example, a portion of the circumference (especially, one circumference of the mount board piece 12) of each mount board 11 and are capable of restricting. Accordingly, there is no unnecessary portion (e.g., the concave and convex portions shown in Fig. 6B) on the mount board piece 12, and the large mount board 11 becomes relatively the smaller because there is no such unnecessary portion.

In the meantime, the LED 21, as shown in Fig. 3, has an anode (positive electrode) 31 and a cathode (negative electrode) 32. And, the anode 31 and the cathode 32 connect to a connector 35 via a connection line 33 (33A, 33B). This connector 35 includes three terminals 36 (36B, 36A, 36B) parallel with one another. Of the three terminals 36 parallel with one another, a central terminal 36 is a positive terminal 36 A, and both terminals 36 are negative terminals 36B (here, a connection line for electrically connecting the anode 31 and the positive terminal 36A to each other is indicated by 33A and a connection line for connecting the cathode 32 and the negate terminals 36B is indicated by 33B).

And, the connector 35, which includes: the positive terminal 36A for electrically connecting the LED 21 and the anode 31 to each other; and the negative terminal 36B for connecting the LED 21 and the cathode 32 to each other, is mounted on the circumference of the mount boards 11 having the various shapes; and the identical electrode terminals 36 of the connectors 35 of neighboring mount boards 11 are electrically connected to each other. In detail, in the case where the mount boards 11 are disposed so as to be in tight contact with one another, the connectors 35 (in short, the identical electrode (positive or negative) terminals 36) are disposed so as to face each other and to be connectable physically and electrically to each other.

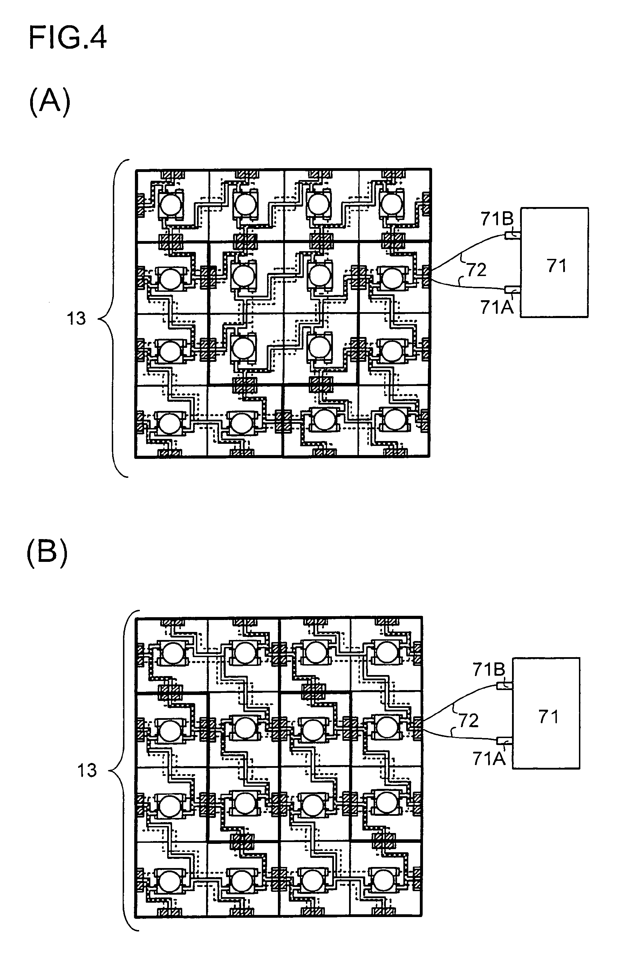

For example, the connector 35 is mounted on every circumference of the mount board pieces 12 corresponding to the circumference of the mount board 11 (see Fig. 2A to Fig. 2G). According to this, as shown in Fig. 4A and Fig. 4B, when a positive power supply terminal 71A of a power supply 71 is electrically connected to the positive terminal 36A of the connector 35 and a negative power supply terminal 71B of the power supply 71 is electrically connected to the negative terminal 36B of the connector 35 via a connection line 72, a current flows into the LED 21.

Especially, even if the mount boards 11 having the different kinds of shapes are disposed so as to be in contact with one another as shown in Fig. 4A and the mount boards 11 having the identical kind of shape are disposed so as to be in contact with one another as shown in Fig. 4B, when a current is supplied to any one of the connectors 35, the LEDs 21 are connected in parallel and receive the current (in other words, in the large mount boards 11, a circuit structure for supplying a current becomes simple).

In short, no matter how the mount boards 11 shown in Fig. 2A to Fig. 2G are disposed, when the mount boards 11 are in tight contact with one another as if they grip one another, the connectors 35 are electrically connected to each other, whereby a current is supplied to the LEDs 21. In addition, to whichever connector 35 the power supply 71 is connected, the current is supplied to all the LEDs 21.

### [Other Embodiments]

Here, the present invention is not limited to the above embodiments, and various modifications are possible without departing from the spirit of the present invention.

For example, in Fig. 1 described above, the plurality of mount boards 11 disposed so as to be in tight contact with one another include the mount boards 11 having the identical kind of shape and the mount boards 11 having the different kinds of shapes mingled with each other. However, without being limited to this, for example, as shown in Fig. 4A, only the mount boards 11 having the different kinds of shapes may be gathered to be in tight contact with one another; and as shown in Fig. 4B, only the mount boards 11 having the identical kind of shape may be gathered to be in tight contact with one another.

In other words, the mount boards 11 having the identical kind of shape and the mount bards 11 having the different kinds of shapes may mingle with each other; only the mount boards 11 having the different kinds of shapes may be used; and the mount boards 11 having the identical kind of shape may be used. In short, the various mount boards 11 are usable in accordance with the size of the backlight unit 49.

Besides, in the above description, the mount board pieces 12 of the mount board 11 have the identical shape (square as the singe kind) as shown in Fig. 2A to Fig. 2G; however, this is not limiting. For example, the square shape mount board pieces 12 and the rectangular shape mount board pieces 12 may be included (in short, various kinds of the mount board pieces 12 are gathered) to form the mount board 11. Of course, the mount board pieces 12 having other shapes may be gathered to form the mount boards 11 having the shapes shown in Fig. 2A to Fig. 2G.

Besides, in Fig. 1, the shape of the plurality of mount boards 11 disposed to be in tight contact with one another is a rectangular shape. However, according the mount boards 11 shown in Fig. 2A to Fig. 2G, the shape of a plurality of the mount boards 11 disposed to be in tight contact with one another becomes a shape as well other than the rectangular shape. Because of this, the mount board unit 13 is compatible with variously shaped backlight units 49.

Besides, in the above description, one LED 21 is mounted on every mount board piece 12; however, this is not limiting. For example, a plurality of the LEDs 12 may be mounted on one mount board piece 12 (in short, at least one LED 21 may be disposed on the mount board piece 12). If such mount board piece 12 on which the plurality of LEDs 21 are mounted is used, a density (distribution density) of the LEDs 21 in the backlight unit 49 is suitably changed.

For example, humans often have their eyes on the center of the liquid crystal display panel; accordingly, there is case where the center is brightened compared with the other portions of the liquid crystal display panel. In such case, when the mount board 11 including the mount board pieces 12 on which a plurality of the LEDs 21 is used, it is possible to dispose the LEDs 21 more tightly near the center of the mount board unit 13 corresponding to the center of the liquid crystal display panel than the other portions.

Besides, as shown in Fig. 2A to Fig. 2G, by changing the way of connecting the four mount board pieces 12, the mount boards 11 having the seven kinds of shapes are formed. However, this is not limiting. For example, the mount boards 11 (e.g., the mount board 11 having twelve kinds of both-side pentominos), in which five square shape mount board pieces 12 are connected in various shapes, may be disposed so as to be in tight contact with one another.

Here, the tetromino and the pentomino are each a kind of polyomino (a polygon formed by connecting edges of a plurality of squares to one another); the shape of the mount board 11 formed by the four mount board pieces 12 is called the tetromino; and the shape of the mount board 11 formed by the five mount board pieces 12 is called the pentomino. Besides, in case where the shape of the mount board 11 is expressed under a rule that "shapes, which are identical to each other only when they are turned over, are different from each other," it is expressed as "one side"; and in case where the shape of the mount board 11 is expressed under a rule that "shapes, which are identical to each other only when they are turned over, are identical to each other," it is expressed as "both sides".

Besides, in the above description, as an example of the digital signage, the display device 69 mounted on the building is described; however, this is not limiting. For example, even the display device 69 mounted on a wall surface in a train is sayable to be a digital signage. Here, the above backlight unit 49 is usable for not only the digital signage but also a liquid crystal display device that is used chiefly for a household.

Besides, the light color emitted from the LED 21 is not especially limited. For example, the LED 21 for emitting red light, the LED 21 for emitting green light, and the LED 21 for emitting blue light may mingle with one another to mix colors so as to generate white light or may generate light having other colors (single color light or mixed color light). In short, the backlight unit 49 may be a full-color light emitting device (light source device). OF course, all the LEDs 21 may be the LED 21 for emitting white light.

Here, it is desirable that a predetermined amount of power is sufficiently supplied to the LED 21. Because of this, it is desirable that the LED 21 is connected, for example, to a not-shown supplied power adjustment device (power adjustment portion) that is incorporated in the backlight unit 49.

### Reference Signs List

- 11: mount board
- 11: L L-shaped portion
- 12: mount board piece
- 13: mount board unit
- 21: LED (point light source, light emitting element)
- 31: anode (positive electrode)
- 32: cathode (negative electrode)
- 33: connection line
- 35: connector
- 36: terminal
- 36A: positive terminal
- 36B: negative terminal
- 43: diffusion plate (diffusion member)
- 44: brightness improvement film (brightness improvement member)
- 49: backlight unit
- 69: display device
- 71: power supply
- 72: connection line

## Claims

1. An illumination device comprising a light source and a plurality of mount boards on which the light source is mounted, wherein
the plurality of mount boards are disposed so as to be in tight contact with one another; a shape of the mount board is a polyomino; at least one kind of the shape includes a portion of a circumference of the mount board that defines an L-shaped portion which encloses a neighboring mount board.

2. The illumination device according to claim 1, wherein
the plurality of mount boards disposed so as to be in tight contact with each other include: mount boards having identical kind of shape and mount boards having different kinds of shapes mingled with each other; only mount boards having the different kinds of shapes; or mount boards having the identical kind of shape.

3. The illumination device according to claim 1, wherein
as the kind of shape of the mount board, there are seven kinds of shapes that include:
an I shape;
a first L shape that is an L shape;
a second L shape obtained by turning over the first L shape;
a first step shape that is a step shape;
a second step shape obtained by turning over the first step shape;
a T shape; and
a quadrangular shape.

4. The illumination device according to any one claims 1 to 3, wherein
the mount boards having various shapes are each an aggregate of a plurality of mount board pieces; and as a kind of shape of the mount board piece, there is a single kind of shape or a plurality of kinds of shapes.

5. The illumination device according to claim 4, wherein
every one of the mount boards includes the mount board pieces to a number of four as a whole; and at least one light source is disposed on every one of the mount board pieces.

6. The illumination device according to any one of claims 1 to 5, wherein
a connector, which is includes a positive terminal electrically connected to a positive electrode of the light source and a negative terminal electrically connected to a negative electrode of the light source, is mounted on a circumference of the mount boards having the various shapes; and
the terminals having identical electrodes of the connectors of neighboring mount boards are electrically connected to each other.

7. The illumination device according to claim 6, wherein
every one of the mount boards is an aggregate of four mount board pieces having shapes identical to one another, and on every one of the mount board pieces, the LED is mounted; and
the connector is mounted on every circumference of the mount boards corresponding to the circumference of the mount board.

8. The illumination device according to any one of claims 1 to 7, wherein
the light source is a light emitting element.

9. The illumination device according to claim 8, wherein
a plurality of the light emitting elements include a red light emitting element, a green light emitting element, and a blue light emitting element mingled with one another.

10. The illumination device according to claim 8, wherein
a plurality of the light emitting elements are white light emitting elements.

11. The illumination device according to any one of claims 1 to 10, further comprising a power adjustment portion that adjusts an amount of power supplied to the light source.

12. The illumination device according to any one of claims 1 to 11, further comprising a diffusion member that diffuses light from the light source.

13. The illumination device according to any one of claims 1 to 12, further comprising a brightness improvement member that transmits the light from the light source to improve brightness.

14. A display device comprising:
the illumination device according to any one of claims 1 to 13; and
a display panel that receives light from the illumination device.

15. The display device according to claim 14, wherein
the display panel is a liquid crystal display device.
